Europäisches Patentamt

European Patent Office

Office européen des brevets

(19)

(11) Publication number: **0 075 679**
**A2**

(12) # EUROPEAN PATENT APPLICATION

(21) Application number: 82106908.5

(22) Date of filing: 30.07.82

(51) Int. Cl.³: **H 01 L 45/00**
**H 01 L 29/08**

(30) Priority: 25.09.81 US 305664

(43) Date of publication of application:
06.04.83 Bulletin 83/14

(84) Designated Contracting States:
DE FR GB

(71) Applicant: Rockwell International Corporation
2230 East Imperial Highway
El Segundo, California 90245(US)

(72) Inventor: Harada, Roy Hiroshi
2749 Mendoza
Costa Mesa, CA 92626(US)

(72) Inventor: Pattanayak, Deva Narayan
22642 Ancona
Laguna Hills, CA 92653(US)

(74) Representative: Wagner, Karl H.
P.O. Box 246 Gewürzmühlstrasse 5
D-8000 Munich 22(DE)

(54) SIMIM electron devices.

(57) An electron device including a semiconductor body comprising an electron emissive source for emitting electrons and a dielectric layer disposed adjacent the electron emissive source, and a collector for collecting electrons emitted from the electron emissive source and transported through the dielectric layer. A control electrode is provided between the electron emissive source and the collector for controlling the current therebetween.

EP 0 075 679 A2

## BACKGROUND OF THE INVENTION

### Field of the Invention

The present invention is concerned with electron devices with ultra-short transit times, and more particularly with semiconductor devices which are fabricated as semiconductor-insulator-metal-insulator-metal (SIMIM) composites, in which charge carriers move through the insulator region. The invention is also related to three terminal electron devices, comprising emitter, grid, and collector elements.

### Description of the Prior Art

The operation of three terminal semiconductor devices has been known in the prior art.

U. S. Patent No. 3,509,432 (Aponick et al) apparently describes a three terminal solid state triode having a gridded control element. A conductive electrode forms an emitter having CdS material deposited thereon in layer 13. The metallic grid element, formed of aluminum approximately 100 Angstroms thick, is provided with a mesh like grid structure and separates layer 13 from an upper CdS layer 19. The grid itself is separated from layer 13 by an isolation layer 14, and from upper layer 19 by an $Al_2O_3$ layer formed on the various surfaces of the grid. A collector electrode is provided on layer 19.

U. S. Patent No. 3,313,989 (Tracy) apparently describes a gridlike control element for use with a thin film triode structure. The grid is provided on oxide layers below an insulator. The combination is disposed between an aluminum emitter and a metallic collector.

U. S. Patent 3,250,967 (Rose) apparently describes a solid state triode having a metal or semiconductor grid located between a semiconductor or insulator emitter and an insulator collector. An insulator layer is provided between the emitter and the grid.

U. S. Patent 2,618,690 (Stuetzer) apparently describes a control electrode atop an n-type semiconductor, for example, and mounted by a sheet of insulator separating the electrode from an output electrode.

U. S. Patent 3,121,177 (Davis) apparently describes a structure, illustrated in Figure 3 of the patent, which includes a control element between two insulating layers, the combined control element located between a conducting film and an electrode. The control element may be in the form of ribs, or a microgrid, as shown in Figures 5 through 9. Figure 9 shows a control element for influencing the barrier between a metal conductor and the collector.

U. S. Patent 2,208,455 (Glaser) apparently describes a triode in which perforated control electrodes of platinum, for example, are embedded in a crystalline dielectric, or blocking layer of CdSe between an anode layer and a cathode layer.

U. S. Patent 2,456,758 (vanGeel) forms a grid of semiconductive material in a blocking layer electrode system. U. S. Patent 2,173,904 (Holst) shows a plurality of grid electrodes 5, 6 connected to grids 4, 4',..., separated by insulating layers and disposed between main metal electrodes.

U. S. Patent 3,184,659 (Cohen) apparently describes a structure with a metal base, an insulating film, a thin conducting metal layer and conducting metal grid in intimate contact therewith.

## REFERENCES

1. (a) T. H. Ning, C. M. Osburn, and H. N. Yu, "Emission Probability of Hot Electrons from Silicon into Silicon Dioxide," Journal of Appl. Phys., Vo. 48, 286 (1977).

   (b) J. L. Moll, N. J. Meyer, and D. J. Bartelink, "Hot Electron Emission from Silicon p-n Junctions Parallel to the Surface," Phys. Rev. Letters, Vol. 7 p. 87 (1961).

2.  Murray A. Lampert, "Simplified Theory of Space-Charge-Limited Currents in an Insulator with Traps," Phys. Rev. Vol. 103, p. 1648 (1956).

3.  See for example (a) G. T. Wright, "A Proposed Space-Charge-Limited Dielectric Triode," Journal Brit. I.R.E., P. 337, May 1960.

    (b)   W. Ruppel and R. W. Smith, "A CdS Analog Diode and Triode," RCA Review p. 702, Dec. 1959.

    (c)   R. Zuleeg, "A Silicon Space-Charge-Limited Triode and Analog Transistor," Solid State Electronics, Vol. 10, 449 (1967).

4.  R. C. Hughes, "Charge-Carrier Transport Phenomena in Amorphous $SiO_2$: Direct Measurement of the Drift Mobility and Lifetime," Phys. Rev. Let. 30, 1333 (1973).

5.  Karl R. Spangenberg, Vacuum Tubes, (McGraw-Hill Book Company, Inc., New York, 1948), p. 191.

6.  Richard Williams, "Photoemission of Electrons from Silicon into Silicon Dioxide," Phys. Rev. 40, A569 (1965).

7.  R. A. Gdula, "The Effects of Processing on Hot Electron Trapping in $SiO_2$," J. Electrochemical Soc. 123, p. 42 (1976).

8.  T. H. Ning, "Hot Electron Emission from Silicon into Silicon Dioxide," Solid State Electron, 21, 273 (1978).

9.  N. D. Arora, S. G. Chamberlain, D. J. Raulston, "Diffusion Length Determination in p-n Junction Diodes and Solar Cells," Appl. Phys. Let. August 1 (1980).

Summary of the Invention

Briefly and in general terms the invention concerns an electron device including a semiconductor body having an electron emissive source for emitting electrons; and a dielectric layer disposed adjacent the electron emissive source. The invention further includes a collector for collecting electrons emitted from the electron emissive source and transported through the dielectric layer.

A high internal electric field is provided in the semiconductor body such that electrons in the emissive source are excited to energies greater than the electron affinity of the semiconductor body. A control electrode is also provided which is disposed between the electron emissive source and the collector region for controlling the current therebetween. Furthermore, a potential is established between the electron emissive source and the collector for deriving an electrical output from the electron device.

The novel features which are considered as characteristic for the invention are set forth in particular in the appended claims. The invention itself, however, both as to its construction and its method of operation, together with additional objects and advantages thereof will be best understood from the following description of specific embodiments when read in connection with the accompanying drawings.

Brief Description of the Drawings

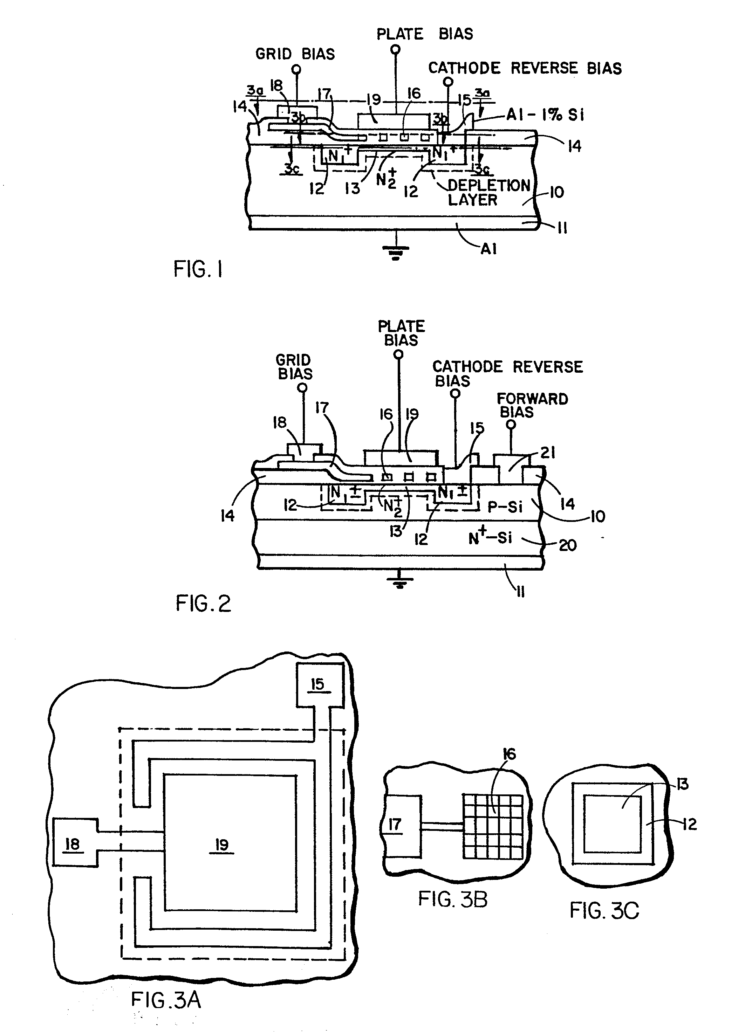

Figure 1 is a highly simplified cross-sectional view of a semiconductor-insulator-metal-insulator-metal (SIMIM) device according to the present invention;

Figure 2 is a cross-sectional view of a SIMIM device according to the present invention incorporating a forward diode;

Figure 3a is a top plan view of the device shown in Figure 1;

Figure 3b is a top view through the 3b-3b plane of the device shown in Figure 1;

Figure 3c is a top view through the 3c-3c plane of the device shown in Figure 1;

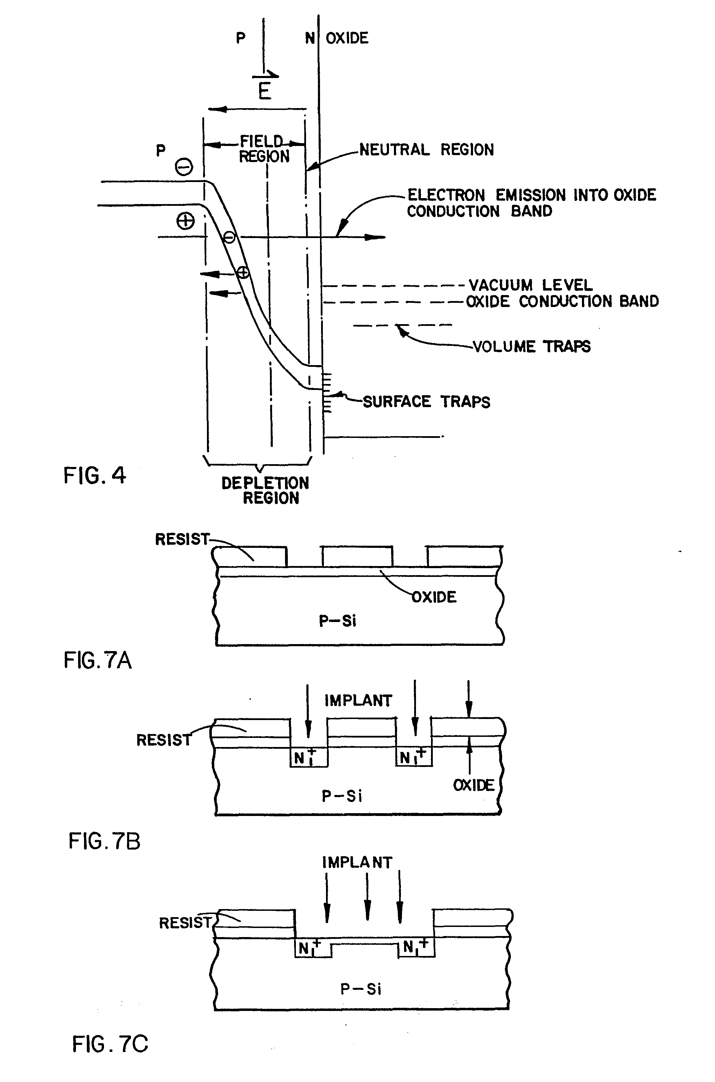

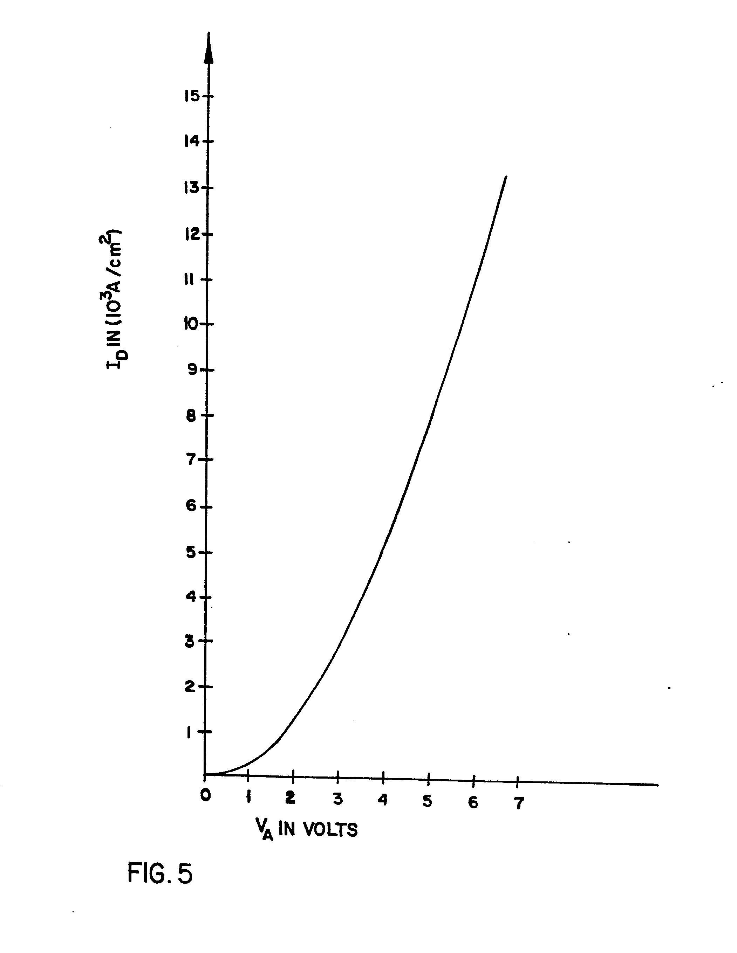

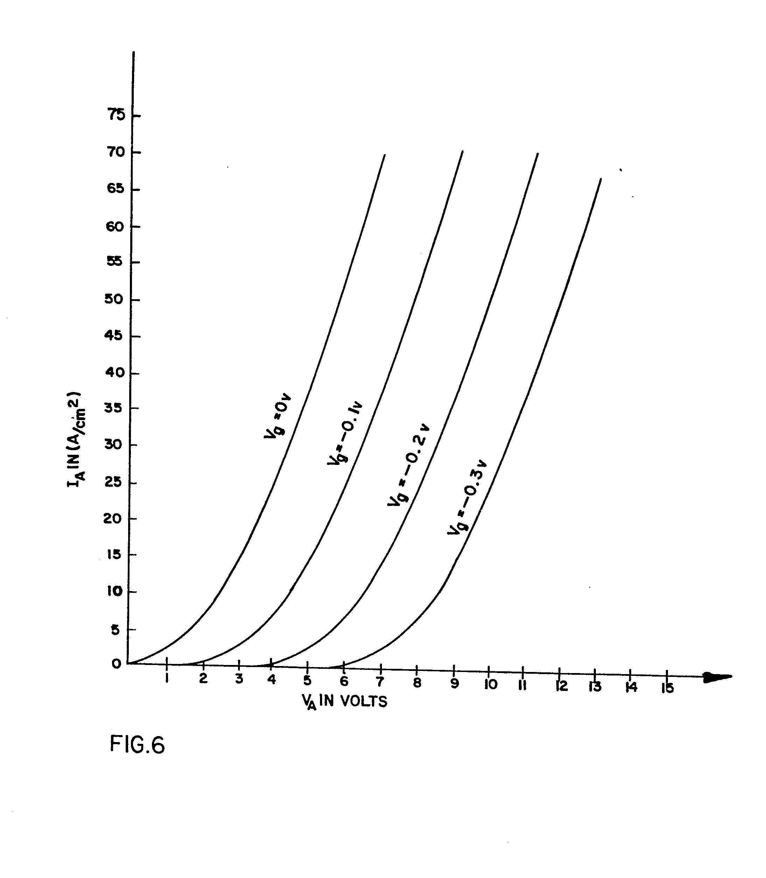

Figure 4 is a potential energy diagram of the operation of the SIMIM device according to the present invention;

Figure 5 is a V-I diagram illustrating the operating performance of a first embodiment of the device according to the present invention;

Figure 6 is a V-I diagram illustrating the operating performance of the device of a second embodiment of the device; and

Figure 7a-7g shows the sequence of steps for fabricating a device according to the present invention.

Description of the Preferred Embodiment

The present invention relates to a new transistor device that utilizes hot electron injection into an insulator and is based upon space charge limited current flow in solids. The preferred embodiment is a three terminal device which comprises emitter, grid and collector elements. The emitter consists of two reverse-biased P-N junctions, one of which operates in the avalanche breakdown mode and thus supplies a substantial number of hot electrons. The space between the emitter and the grid and the collector is an insulator into which the hot electrons from the emitter are injected having sufficient energy to surmount the work function barrier. The current transport in the insulator is space charge limited. This device therefore is a solid state analogue of a vacuum tube. Attention may be directed to references (1) and (2) for further information.

The design of the present invention differs from the earlier design of such solid state devices, such as described in reference 3, both in its emitter design and the fact that the insulator used is amorphous silicon dioxide rather than a wideband semiconductor such as CdS. Since the present invention is a composite of semiconductor, insulator, metal, insulator and metal, the acronym of a "SIMIM" device is applied thereto.

Turning next to the drawing, Figure 1 is a highly simplified cross-sectional view of a semiconductor-insulator-metal-insulator-metal (SIMIM) device according to the present invention. The embodiment shown in Figure 1 consists of a substrate 10 of a first conductivity type. The substrate 10 is contacted on its lower surface by an aluminum layer 11, which is connected to ground.

A first implant 12 which is designated as $N_1^+$ is provided on the upper surface of the substrate 10. A second implant 13 labelled $N_2^+$ in the figure, is also provided adjacent the top major surface of the substrate 10 adjacent to the first implant 12. A dielectric layer 14 is provided over the substrate layer 10. A contact 15 is provided which extends through an aperature in the dielectric layer 14 to make physical and electrical contact with the $N_1^+$ implant 12. As shown in the figure, the contact 15 is a cathode reverse bias contact and is preferably composed of an aluminum-silicon alloy, consisting of aluminum with 1% silicon added. The middle electrode which is composed of a refractory metal is provided within the dielectric layer 14 over the $N_2^+$ implanted portion 13 of the upper surface of the substrate. This refractory metal is patterned into a grid 16 and from the grid the refractory metal is extended to a pad 17. When the contact to 17 is opened at the appropriate time, a contact 18, again preferably composed of an aluminum silicon alloy, is provided which makes physical and electrical contact to the refractory metal pad 17. As indicated on the figure, the contact 18 is connected to a source of an electrical potential for the grid bias of the electron device according to the present invention.

An electrically conducting layer 19 is also applied over the dielectric layer 14 in the region of the grid 16. Such layer forms the plate of the 3 terminal electron device according to the present invention and is electrically connected to an electric potential for a source of plate bias as shown in the figure.

Turning now to Figure 2, there is shown an alternative embodiment of the present invention in which the substrate is composed of two layers; a first layer 20 of N conductivity type and a second layer disposed over the first layer of a P conductivity type. The implants 12 are disposed in the second layer 10 so that a rectifying junction is formed between the regions 12 and the layer 10. The embodiments of Figure 2 also include a forward diode which is implemented by employing a contact 21 which makes physical and electrical contact with the layer 10. The contact 21 is connected to a source of potential labelled "forward bias" in the figure. Like parts have similar reference numerials in the various figures, so a description of such elements will not be repeated.

Turning next to Figure 3, there is shown a sequence of top views at various levels of the device shown in Figure 1. Figure 3a is a top plan view of the surface of the device shown in Figure 1 more particularly showing the grid bias contact 18, the plate bias contact 19, and the cathode reverse bias contact 15. Figure 3b is another top view through the 3b-3b plane of the device shown in Figure 1 at the level of the grid 16. Figure 3b in particular shows the configuration of the grid 16 as seen from the top, which is shown to be an intermeshed wire grid in a rectangular pattern. The grid 16 is connected to the conductor 17 of the same material which in turn makes contact to the grid bias contact 18.

Figure 3c is a top view through the 3c-3c device as shown in Figure 1 at the level of the upper surface of the semiconductor substrate 10. Figure 3c in particular shows the $N_2^+$ implant region 13 as a generally square area, and the $N_1^+$ region 12 surrounding the region 13 on the periphery thereof.

As mentioned above, the emitter consists of a reverse biased P-N junction. The avalanche electrons produced in the depletion layer gain enough energy from the high electric field in the depletion region and diffuse through the neutral region and are injected into the conduction band of $SiO_2$. Reference should be made to the potential energy diagram in Figure 4. The hot electron injection efficiency is the ratio between the emitted electron current into the insulator and the reverse bias current that flows in the P-N junction. Electron emission into vacuum from reverse biased P-N junctions and from depletion regions in silicon into $SiO_2$ have been observed in the past, as noted in reference 1a and 1b. The emission efficiency from the reverse bias P-N junction into vacuum depend upon several factors, the key ones being the work function barrier magnitude and the distance in the depletion and neutral regions (shown in Figure 4) the electron has to travel before being emitted. Assuming the emission efficiency to be denoted by f, we find from measurement of reverse current in silicon P-N junctions that one may expect the emitter current density $I_{emitter}$ of the device according to the present invention to be of the order of

$$I_{emitter} \simeq f \times 10^4 \text{ A/cm}^2 \qquad (1)$$

Thus, it is important to have high efficiency so that the current flow in the device is not emitter limited. From the existing literature (such as reference 1a) we estimate that f can be of the order of

$10^{-4}$. We believe with proper design of the emitter it can be increased substantially.

The electrons emitted into the $SiO_2$ would move by a collision dominated transport mechanism. It has been shown in reference 4 that once the electrons are in the conduction band they move with uniform mobility, with values of

$$\mu_o = 20 - 40 \quad cm^2/V\text{-Sec.} \qquad (2)$$

The current flow in insulators is space charge limited and has been described by Lampert (reference 2), whose analysis is followed here. The following simplifying assumptions are made:

(a)    It is assumed that electrons leave the emitter with zero initial velocity. This is really not the case and corrections must be applied (reference 5).

(b)    The traps are completely filled. Several investigations in measuring the trap densities of amorphous $SiO_2$ layers have been reported. It is found that surprisingly the volume trap densities in amorphous layers of $SiO_2$ are lower than that of many single crystals and is of the order of $10^{14}$ per $cm^3$ (reference 6). The surface trap density (reference 7) $N_{ts}$, at the silicon and $SiO_2$ interface is of the order of $10^{11}$ per $cm^2$.

The key formulas that are relevant to the operation of our SIMIM device will now be presented. The voltage threshold, $V_T$, beyond which the current flow will approach that of the trap free case is given by

$$V_T = \frac{ed}{2\epsilon} [2 N_{ts} + N_{tv}d], \qquad (3)$$

$$\equiv \frac{ed}{\epsilon} N_{teff}$$

where d is the thickness of the insulator $N_{ts}$ and $N_{tv}$ are the surface and bulk trap densities, respectively. The transit time of electrons with mobility $\mu$ in traversing a distance d under a potential difference V is given by

$$t_r = \frac{4}{3\mu} \frac{d^2}{V} , \qquad (4)$$

and the space charge limited current I is given by

$$I = \frac{9\mu\varepsilon AV^2}{8 \, d^3} , \qquad (5)$$

where $\varepsilon$ is the dielectric constant of the oxide and A is the area of the emitter (the collector area is assumed to be the same). As in the case of the vacuum tube triode (discussed in reference 5), one finds that the anode current $I_A$ is given approximately by the expression

$$I_A \simeq \frac{9\varepsilon\mu A \, V_{eff}^2}{8 \, d_{eff}^3} , \qquad (6)$$

where

$$d_{eff} = d_g \left( 1 + \frac{1}{G} \left( \frac{d_a - d_g}{d_g} \right)^{3/2} \right)^{2/3} \qquad (7)$$

and

$$V_{eff} = V_g + V_a/G \qquad (8)$$

In Eqs. (7) and (8) G denotes the amplification factor of the triode and is primarily a function of the electrode spacings, $d_a$ is the emitter to anode spacing and $d_g$ is the emitter to grid spacing. $V_a$ and $V_g$ are the anode and grid potential respectively with reference to the emitter potential. In Table 1 we compute the values of $V_T$ and $t_r$, as a function of oxide thickness and potential difference. The mobility was taken to be 20 $cm^2$/V-sec.

| | | Table 1 | |
|---|---|---|---|
| d in µm | $N_{teff}cm^{-2}$ | $t_r$ in psec at 5 volts | $V_T$ in volts |
| .3 | | 12 | 1.4 |
| .2 | $10^{11}$ | 5.3 | 0.9 |
| .1 | | 1.3 | 0.46 |

From the figures in Table 1, it is clear that although the mobility of electrons in $SiO_2$ is quite low, transit times of the order of few picoseconds can be realized. The traps also will not be a limiting factor for voltages greater than the threshold voltages. The key factor is that the low mobility is compensated by the short distances that the electrons have to travel, and thus leads to low transit times which implies high frequency potentiality of a SIMIM device.

Moreover, the effects of trapping do not obstruct current flow in $SiO_2$ of submicron thickness. The "diode like" and "triode like" characteristics of such devices following the analysis presented earlier have been computed and are presented in Figure 5 and Figure 6, respectively. The triode characteristics in Figure 6 are for a situation in which the emitter to collector distance is taken to be 0.3µm and the emitter to grid distance is taken to be 0.15µm. The

amplification factor is taken to be 20 and is considered to be constant. No account has been taken for the fact that the electrons do not leave the emitter with zero velocity as has been mentioned earlier. This rough calculation is made to estimate the current levels expected for the dimensions employed. It is worth noticing that with efficiencies of the order of $f \backsim 10^{-2}$ the triode current for this particular design is not emitter limited for an anode voltage of the order of 10 volts.

It is clear from the foregoing analysis that the device according to the present invention realizes space charge limited diode and triode operation by employing a reverse biased P-N junction in the avalanche breakdown mode and using $SiO_2$ as the insulating medium separating the grid and the collector.

The actual fabrication procedure of a device according to the present invention will be discussed next making reference to Figures 7a-7g.

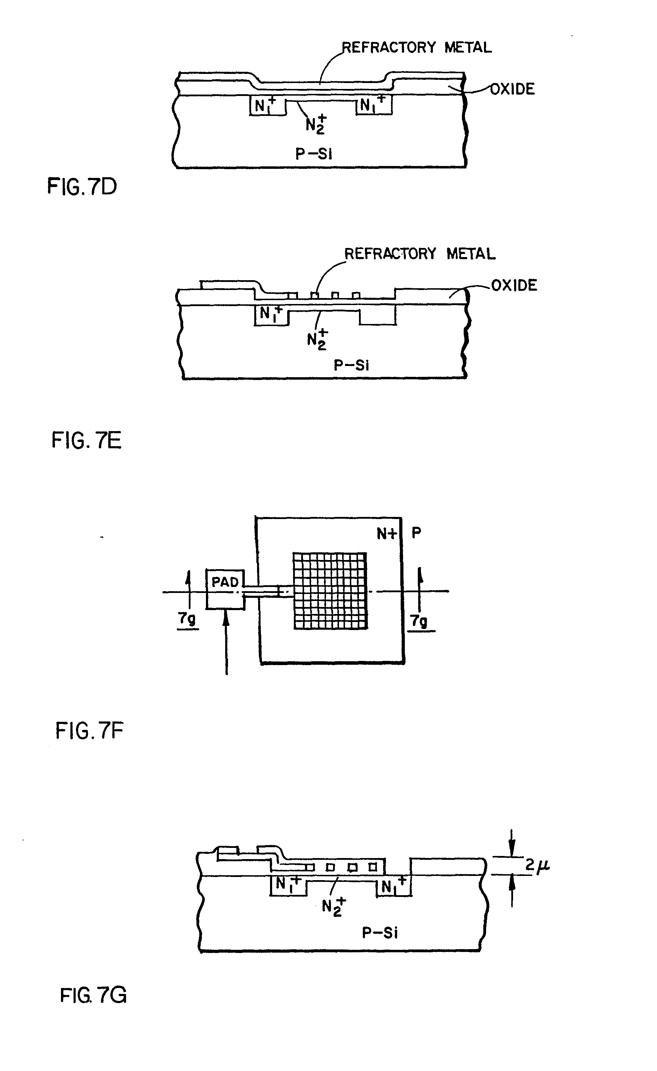

A processing sequence for achieving the SIMIM device is described and the various process steps are illustrated in Figures 7a-7g, with a top view shown (figure 7f) in order to better illustrate the actual device configuration.

To keep the breakdown voltage of the device reasonably low, the starting substrate material would be low resistivity (100) p-type silicon ~0.05 - 0.5Ω -cm. shown in Figure 7a. The silicon wafers are thermally oxidized, say at $1000^{O}C$ in steam, to grow ~3000Å of oxide. A photolithographic step (mask 1) is performed to open up regions for the first phosphorus ($N_1^+$) implant as shown in Figure 7b. The oxide is etched and phosphorus is implanted as indicated in Figure 7b, with the photoresist acting as a mask. The phosphorus is implanted ~$7^O$ off normal incidence to prevent channeling. The implant dose and energy is chosen so as to obtain a surface concentration approximately $10^{20}$ $cm^{-3}$ and a junction depth of 0.5μm - 1μm.

The resist is plasma stripped and with a second mask the second phosphorus ($N_2^+$) regions are defined and the oxide etched followed by a shallow phosphorus implant (see Figure 7c). The breakdown voltage of the $N_2^+$-P junction should be lower than the $N_1^+$-P junction so that the source of hot electrons would be from the former. This step and the following oxidation step are considered the critical ones for achieving a working device. The dose and energy is chosen so that the surface concentration is approximately $~10^{19}$ cm$^{-3}$ and the junction is $~500$-1000 Angstroms from the surface after the oxidation step. If the junction is much over 1000 Angstroms, the number of electrons with sufficient energy to cross the undepleted $N_2^+$ region and surmount the Si-SiO$_2$ barrier would be greatly diminished.

The oxide to be grown after the $N_2^+$ implant requires a dry oxygen ambient and subsequent nitrogen anneal to minimize the trap density in the oxide (reference 7). The thinner the oxide, the lower the time temperature product and, therefore, the result would be minimum junction movement. Also, the current is inversely proportional to the cube of the total oxide thickness. Therefore, an oxide thickness of $~500$ Angstroms is selected to be grown at a temperature of 900$^\circ$C in order to satisfy the requirements of minimal junction movement and maximum current. As an alternative, high pressure oxidation at lower temperatures may be used. After the oxide has been grown, approximately 500 to 2000 Angstroms of a refractory metal such as tungsten or molydenum would be deposited (see Figure 7d).

The refractory metal is then defined into a grid pattern photolithographically using mask 3, then the unwanted metal would be appropriately etched and the resist stripped resulting in the structure shown in cross-section in Figure 7e, and in a top view in Figure 7f. The refractory metal grid could be made as narrow as 0.5μm utilizing electron beam lithography.

Next, 500 Angstroms of low pressure CVD oxide is deposited, densified and annealed ($~850^\circ$C) before the contacts are opened with mask 4 (see Figure 7g). The wafers are then metallized with the 0.99 Al 0.01 Si alloy, the metal pattern defined with mask 5 and etched. The resist is stripped and any oxide remaining on the back of the wafer is etched clear. Aluminum is then deposited on the wafer back. The wafers are then sintered to render ohmic the metal semiconductor contacts (see Figure 1). The electron supply within the depletion layer of a reverse biased diode at breakdown can be increased further by incorporating into the structure of Figure 1 another junction which can be forward biased as shown in Figure 2. As long as the edge of the depletion layer is within a diffusion length most of the electrons generated at the forward biased P-N junction should be collected (reference 9).

While the invention has been illustrated and described as embodied in a SIMIM Electron Device, it is not intended to be limited to the details shown, since various modifications and structural changes may be made without departing in any way from the spirit of the present invention.

It will be obvious to those skilled in the art that the semiconductor device according to the present invention can be implemented with various semiconductor technologies and different combinations of known process steps, and that the preferred embodiments illustrated here are merely exemplary. The depth of penetration of the various zones and regions and in particular the configuration and distance between the active zones of the transistor devices, as well as the concentrations of dopant species, and/or their concentration profiles, can be chosen depending upon the desired properties. These and other variations can be further elaborated by those skilled in the art without departing from the scope of the present invention.

The present invention is moreover not restricted to the particular embodiments of a SIMIM Electron Device described. For example, it may be pointed out that semiconductor materials other than silicon, for example, $A_{III}-B_V$ compounds may be used. Furthermore, the conductivity types in the embodiment may be interchanged and corresponding to such change, the polarity of the respective operating voltages adapted. Moreover, the voltage level and the static or dynamic nature of the signals applied to the various terminals and gates of the device, as well as the voltage sources, may be suitably selected as desired for a particular application. Other types of semiconductor circuits including bipolar junction field effect transistor, MNOS (metal electrode-silicon nitride, silicon oxide-semiconductor), MAOS (metal aluminum oxide, silicon oxide, semiconductor), MAS (metal, aluminum oxide, semiconductor), floating gate FETs, and AMOS FETs (avalanche MOS FETs), may be used as well.

Without further analysis, the foregoing will so fully reveal the gist of the present invention that others can, by applying current knowledge, readily adapt it for various applications without omitting features that, from the standpoint of prior art, fairly constitutes essential characteristics of the generic or specific aspects of this invention, and, therefore, such adaptations should and are intended to be comprehended within the meaning and range of equivalence of the following claims.

What is claimed is:

Claims

1.     An electron device comprising:
a semiconductor body comprising an electron emissive source for emitting electrons;
a dielectric layer disposed adjacent said electron emissive source, and collector means for collecting electrons emitted from said electron emissive source and transported through said dielectric layer;
means for providing a high internal electric field in said semiconductor body such that electrons in said emissive source are excited to energies greater than the electron affinity of said semiconductor body;
control electrode means disposed between said electron emissive source and said collector means  for controlling the current therebetween; and
means for establishing a potential between said electron emissive source and said collector means for deriving an electrical output from said electron device.

2.     A device as defined in Claim 1, wherein said electron emissive source comprises a layer of semiconductor material of a first conductivity type.

3.     A device as defined in Claim 1 wherein said collector means comprises a layer of metal.

4.     A device as defined in Claim 1, wherein said electron emissive source is disposed on a semiconductor substrate.

5.     A device as defined in Claim 1 wherein said electron emissive source comprises first and second adjacent layers of semiconductor material of opposite conductivity type, said first layer being a relatively thin layer, said second layer being a relatively thick layer, a rectifying junction formed between said first and said second layers and biased such that electrons flow from said second layer.

6.     A device as defined in Claim 5 wherein said electron emissive source includes a PN-type junction, means for providing a reverse bias on said junction so that a high electric field is produced in the region of the junction of sufficient magnitude to excite conduction band electrons in said region to energies greater than the electron affinity of said semiconductor material such that the electrons are emitted from the surface of said first layer near said junction into said dielectric layer.

- 17 -

7.    An electron device comprising:

an electron emissive source for emitting electrons, comprising a body of semiconductor material;

a dielectric body disposed adjacent said electron emissive source;

collector means disposed for collecting electrons emitted from said electron emissive source and transported through said dielectric body;

means disposed between said electron emissive source and said collector means for controlling the transfer of electrons therebetween; and

means for establishing a potential between said electron emissive source and said collector means for deriving an electrical output from said electron device.

8.    A device as defined in Claim 7, wherein said electron emissive source comprises a layer of semiconductor material of a first conductivity type.

9.    A device as defined in Claim 7, wherein said collector means comprises a layer of metal.

10.    A device as defined in Claim 7, wherein said electron emissive source comprises first and second adjacent layers of semiconductor material of opposite conductivity type, said first layer being a relatively thin layer, said second layer being a relatively thick layer, a rectifying junction formed between said first and said second layers and biased such that electrons flow from said second layer.

FIG. I

FIG.2

FIG.3A

FIG. 3B

FIG. 3C

P | N | OXIDE

E

FIELD REGION — NEUTRAL REGION

ELECTRON EMISSION INTO OXIDE CONDUCTION BAND

VACUUM LEVEL
OXIDE CONDUCTION BAND

VOLUME TRAPS

SURFACE TRAPS

P

**FIG. 4**

DEPLETION REGION

RESIST

OXIDE

P—Si

**FIG. 7A**

IMPLANT

RESIST

$N_i^+$   $N_i^+$

OXIDE

P—Si

**FIG. 7B**

IMPLANT

RESIST

$N_i^+$   $N_i^+$

P—Si

**FIG. 7C**

FIG. 5

0075679

0075679

FIG.6

FIG. 7D

FIG. 7E

FIG. 7F

FIG. 7G